# EUROPÄISCHE PATENTSCHRIFT

(11) **EP 2 140 745 B1**
(45) Veröffentlichungstag und Bekanntmachung des Hinweises auf die Patenterteilung: **18.11.2015**
(21) Anmeldenummer: 08716017.2
(22) Anmeldetag: 25.02.2008
(51) Int. Cl.: H05K 7/20

(54) **ELEKTRISCHES GERÄT**
ELECTRICAL DEVICE
APPAREIL ÉLECTRIQUE

(30) Priorität: 23.03.2007 DE 102007014713
(43) Veröffentlichungstag der Anmeldung: 06.01.2010
(73) Patentinhaber: SEW-EURODRIVE GmbH & Co. KG, 76646 Bruchsal (DE)
(72) Erfinder: LEONHARDT, Jörg, 76646 Bruchsal (DE); SCHMIDT, Josef, 76676 Graben-Neudorf (DE)
(74) Vertreter: Tüngler, Eberhard
(86) Internationale Anmeldenummer: PCT/EP2008/001472
(87) Internationale Veröffentlichungsnummer: WO 2008/116539

(56) Entgegenhaltungen:
- EP-A2- 0 340 520
- DE-A1- 10 004 474
- DE-A1- 10 014 457
- DE-A1- 19 624 475
- JP-A- 10 224 065
- US-A- 6 065 530
- US-B1- 6 704 202

## Beschreibung

Die Erfindung betrifft ein elektrisches Gerät.

Aus der DE 3223624 ist ein Kühlkörper bekannt, der sowohl an der Innenseite als auch an der Außenseite Kühlrippen aufweist. Im Inneren befindet sich Luft zum konvektiven Wärmetransport zwischen den wärmeerzeugenden Bauelementen (6) und dem Kühlkörper.

Aus der DE 3700349 ist eine Wanne zur Aufnahme von Vergussmasse bekannt.

Aus der JP 10 224065 A ist eine Kühlanordnung für eine elektronische Schaltung bekannt.

Aus der US 6 704 202 B1 ist eine Leistungssteuerung und ein Kompressor für ein Kühlsystem bekannt.

Das Dokument US 6 065 530 beschreibt ein elektrisches Gerät mit einem einen Kühlkörper umfassenden Gehäuse, einer Leiterplatte und einer umgebenden Vergussmasse. Erhebungen sind an der Innenseite des Kühlkörpers vorgesehen.

Der Erfindung liegt daher die Aufgabe zugrunde, ein elektrisches Gerät weiterzubilden, wobei die Entwärmung verbessert und das Gerät einfach fertigbar sein soll.

Erfindungsgemäß wird die Aufgabe bei dem elektrischen Gerät nach den in Anspruch 1 angegebenen Merkmalen gelöst.

Wichtige Merkmale der Erfindung bei dem elektrischen Gerät sind, dass es ein einen Kühlkörper umfassendes Gehäuseteil und eine Leiterplatte umfasst, die mit Wärme erzeugenden Bauelementen (6) und mindestens einem Leistungsmodul bestückt ist,
wobei die Leiterplatte in einer mit Vergussmasse zumindest teilweise befüllten Schale vorgesehen ist, insbesondere mit der Schale verbunden ist,
wobei das Leistungsmodul an seiner Oberfläche eine höhere Temperatur als die Bauelemente an ihrer Oberfläche aufweist, insbesondere als Spitzentemperatur während des Betriebs des Geräts,
wobei die Leistungsmodule eine Kontaktfläche aufweisen, die in Berührung steht mit einer Kontaktfläche des Kühlkörpers zur Ableitung von Wärme an den Kühlkörper,
wobei die Innenseite des Kühlkörpers mit der Vergussmasse in wärmeleitender Verbindung steht, insbesondere direkt oder über eine auf der Vergussmasse aufliegende Folie,
wobei Entwärmung der Bauelemente über die Vergussmasse zum Kühlkörper hin vorgesehen ist.

Von Vorteil ist dabei, dass thermisch verschieden belastbare Bauteile, also beispielhaft Bauelemente und Leistungsmodul, über denselben Kühlkörper entwärmbar sind, der durch die direkte Kontaktflächen-Berührung in diesem Kontaktbereich die Temperatur des Leistungsmoduls aufweist. Die Vergussmasse ist vorteiligerweise schwingungsdämpfend, mechanisch stabilisierend, elektrische Isolationsfestigkeit erhöhend, gut wärmeleitend ausführbar. Außerdem ist die Fertigung des Geräts einfach und kostengünstig ausführbar.

Erhebungen sind an der Innenseite des Kühlkörpers in die Vergussmasse sich hinein erstreckend vorgesehen. Von Vorteil ist dabei, dass durch die Vergrößerung der Oberfläche zur Vergussmasse hin der Wärmeübergangswiderstand vermindert ausgeführt ist. Außerdem sind die Erhebungen derart ausführbar, dass ihre Spitzen in die Umgebung von zu entwärmenden Bauelementen gerichtet sind und somit den Wärmeübergangswiderstand vom Bauelement zum Kühlkörper möglichst klein halten.

Bei einer vorteilhaften Ausgestaltung ist die Umgebungstemperatur der Bauelemente, insbesondere in der umgebenden Vergussmasse, höher, insbesondere ist dauerhaft höher, als die maximal zulässige Umgebungstemperatur, insbesondere bei Luft als umgebendem Medium. Von Vorteil ist dabei, dass durch das Vergießen eine verbesserte Wärmeabfuhr und Wärmeaufspreizung in die Vergussmasse erreicht ist und somit auch Herstellerangaben für die maximal zulässige Umgebungstemperatur nicht eingehalten werden müssen. Insbesondere ist dabei die Erkenntnis überraschend, dass der durch die Vergussmasse der spezifische Wärmeübergangswiderstand vom Oberflächenmaterial des Bauelements zur Vergussmasse hin stark verringert ist und somit die Wärme viel besser abfließt als bei Luft, obwohl bei Luft der konvektive Transport zur Wärmeabfuhr beiträgt und bei der Vergussmasse nur eine unwesentlicher Beitrag zur Wärmeabfuhr konvektiv erfolgt, da die Viskosität und Eigenklebrigkeit sehr hoch ist.

Bei einer vorteilhaften Ausgestaltung ist die maximal zulässige Umgebungstemperatur eine Herstellerangabe, insbesondere ist bei dessen dauerhafter Überschreitung eine Zerstörung des Bauelements wahrscheinlich oder sogar sicher ist. Von Vorteil ist dabei, dass die Herstellerangaben ein Betrieben bis zu dieser maximal zulässige Umgebungstemperatur erlauben und dabei eine unwesentliche Ausfallwahrscheinlichkeit vorliegt, bei Überschreiten aber die Wahrscheinlichkeit ansteigt.

Erfindungsgemäß sind die Erhebungen Kühlrippen und/oder Kühlfinger. Von Vorteil ist dabei, dass einfache und kostengünstige Maßnahmen ausreichen.

Die Erhebungen sind an der Innenseite auf ein jeweiliges Bauelement gerichtet zur Verringerung des Wärmeübergangswiderstandes vom Bauelement zum Kühlkörper. Von Vorteil ist dabei, dass abhängig von der Positionierung des Bauelements bei der Bestückung die Erhebungen vorgesehen sind und somit ein optimierter Wärmeübergang erreichbar ist.

Bei einer vorteilhaften Ausgestaltung weist der Kühlkörper an seiner Außenseite Erhebungen, wie Kühlrippen und/oder Kühlfinger, auf. Von Vorteil ist dabei, dass eine Vergrößerung der Oberfläche und somit Verbesserung für den Wärmeübergang vom Kühlkörper an das außen umgebende Medium erreichbar ist.

Bei einer vorteilhaften Ausgestaltung ist die Vergussmasse ein siliconhaltiges Gel, Insbesondere ein Siliconkautschuk. Von Vorteil ist dabei, dass im Gel Schwingungsdämpfung verbessert ist gegenüber einer gummiartigen Masse, dass eine ausgeprägte Eigenklebrlgkeit vorhanden ist und somit das Bestreben des Zurückfließens in die ursprüngliche Form vorhanden ist. Somit werden die Erhebungen besonders gut umschlossen.

Mittels entsprechender konvexer Ausbildung der Erhebungen in den Innenraum hinein ist auch die Bildung von Luftblasen verhinderbar oder zumindest verminderbar.

Bei einer vorteilhaften Ausgestaltung weist die Vergussmasse eine Viskosität von 500 bis 10 000 mPa s, insbesondere 800 bis 1200 mPa s, auf. Von Vorteil ist dabei, dass die Vergussmasse sich an Änderungen der mechanischen Begrenzung anpasst und sich besonders gut anschmiegt an die Leiterplatte, die Bauelemente und die an der Innenseite des Kühlkörpers vorgesehenen Erhebungen des in die Vergussmasse hinein eingedrückten Kühlkörpers.

Bei einer vorteilhaften Ausgestaltung weist die Vergussmasse eine Wärmeleitfähigkeit auf, die mindestens 6 mal höher ist als die Wärmeleitfähigkeit bei Luft bei Raumtemperatur und 1 bar, insbesondere mindestens 8 mal höher. Von Vorteil ist dabei, dass eine besonders gute Entwärmung ermöglicht ist. Dabei ist aber die Vergussmasse im Unterschied zu Wärmeleitpaste elektrisch sehr gut isolierend und isolationsfest.

Erfindungsgemäß ist auf der Vergussmasse eine Folie aufgebracht. Von Vorteil ist dabei, dass ein Schutz gegen Verschmutzung bei der Lagerung der Schale vor Zusammenbau des Geräts vorsehbar ist.

Erfindungsgemäß berührt die Innenseite des Kühlkörpers die Folie und somit ist der Wärmetransport von dem jeweiligen Bauelement im Wesentlichen über die Vergussmasse und danach die Folie bis zum Kühlkörper und von dort an die Umgebung vorgesehen. Von Vorteil ist dabei, dass die Folie derart dünn ausführbar ist, dass der Wärmeübergangswiderstand nur geringfügig verschlechtert wird. Außerdem ist die Folie mit Ausnehmungen ausführbar, so dass die Kontaktflächen der Leistungsmodule ungestört in Kontakt bringbar sind mit den Kontaktflächen des Kühlkörpers. Die Folie hat den weiteren Effekt, dass die Wärme etwas besser gleichverteilt wird in der Vergussmasse in Richtung parallel zu den Erhebungen des Kühlkörpers und somit die Wärmekapazität der Vergussmasse bei thermischer Wechselbelastung positiv verbessert beiträgt.

Bei einer vorteilhaften Ausgestaltung sind die Bauelemente und/oder die Leistungsmodule mittels SMD-Technik montiert, insbesondere sind also ihre elektrischen Anschlusselemente nur auf einer Seite der Leiterplatte aufliegen und dort mittels Lötverbindung elektrisch verbunden. Von Vorteil ist dabei, dass eine automatische Bestückung besonders einfach ausführbar ist.

Bei einer vorteilhaften Ausgestaltung ist die Entwärmung der Leistungsmodule und Wärme erzeugenden Bauelemente passiv vorgesehen, insbesondere sind also keine Lüfter oder dergleichen vorgesehen. Von Vorteil ist dabei, dass Komponenten einsparbar sind.

Bei einer vorteilhaften Ausgestaltung umfasst ein Leistungsmodul einen elektronischen Leistungsschalter, wie IGBT oder MOSFET. Von Vorteil ist dabei, dass das Leistungsmodul als einzelner Leistungsschalter oder als Ansammlung von Leistungsschaltern ausführbar ist. Die Kontaktfläche zum Kühlkörper hin ist vorteiligerweise aus Aluminium ausführbar. Ebenso ist vorzugsweise der Kühlkörper aus Aluminium ausführbar, wie auch die weiteren Gehäuseteile des Geräts. Darüber hinaus ist vorzugsweise eine druckgussfähige Ausführung aller Gehäuseteile des Geräts gewählt und die mechanische Ausformung entsprechend gestaltet, damit mindestens ein Schieber herausziehbar ist beim Herstellvorgang.

Bei einer vorteilhaften Ausgestaltung umfasst das Gerät in mehreren Halbbrücken zusammengeschaltete Leistungsschalter. Insbesondere sind die Halbbrücken von einem Wechselrichter umfasst zur Erzeugung von einen Elektromotor versorgendem Drehstrom. Von Vorteil ist dabei, dass ein Kompaktantrieb herstellbar ist, dessen Wärme aus dem Getriebe und Motor über ein zentrales Gehäuseteil herausführbar ist und die Wärme der Elektronik über ein lösbar verbindbares Gehäuseteil, welches einen Kühlkörper umfasst, der insbesondere mittels des Kontaktes mit der Vergussmasse besonders gut an die Elektronik ankoppelbar ist. Somit liegt eine wärmetechnische Trennung zwischen Elektronik und Getriebemotor vor.

Erfindungsgemäß ist die Schale in einem zentralen Gehäuseteil lösbar verbunden, wobei das den Kühlkörper umfassende Gehäuseteil auf das zentrale Gehäuseteil verbindbar ist. Von Vorteil ist dabei, dass die Vergussmasse gehalten ist durch die Schale, die außerdem auch zur wärmetechnischen Trennung, also Wärmesperre beiträgt.

Erfindungsgemäß umfasst das zentrale Gehäuseteil Mittel zur Verbindung mit der Schale und auch Lageraufnahmebereiche zur Aufnahme mindestens eines der Lager des Rotors des Motors und mindestens eines der Lager einer abtreibenden Welle eines Getriebes, dessen eintreibende Welle mit der Rotorwelle verbunden ist oder die Rotorwelle ist. Insbesondere ist das zentrale Gehäuseteil zur Entwärmung des Motors und/oder des Getriebes vorgesehen und zwischen dem den Kühlkörper umfassenden Gehäuseteil und dem zentralen Gehäuseteil ist eine Wärmesperre vorgesehen. Von Vorteil ist dabei, dass zwar das zentrale Gehäuseteil die Schale mechanisch hält, in welcher die Leiterplatte vorgesehen ist, jedoch eine wärmetechnische Trennung trotz der mechanischen Verbindung vorsehbar ist. Das Material der Schale ist als entsprechender Kunststoffspritzguss mit entsprechend hoher Wärmeleitfähigkeit wählbar.

Bei einer vorteilhaften Ausgestaltung ist die Wärmesperre zumindest teilweise durch eine lange, an der Oberfläche des Gehäuses verlaufende kürzeste Verbindungslinie zwischen dem Oberflächenbereich des Kühlkörpers und demjenigen Oberflächenbereich, in welchem der wesentliche Teil der Wärme des Motors und/oder des Getriebes einströmt, realisiert. Von Vorteil ist dabei, dass eine bloße auskragende Ausformung oder anderen Ausformungen mit entsprechend langen Wegen eine Wärmesperrenwirkung verstärkbar ist, obwohl die Gehäuseteile aus Aluminium gefertigt sind und somit gute Wärmeleiter sind.

Zusätzlich ist auch an der lösbaren Verbindungsstelle der Gehäuseteile eine Wärmesperre, wie Gummiteil oder dergleichen vorsehbar.

Weitere Vorteile ergeben sich aus den Unteransprüchen.

Die Erfindung wird nun anhand von Abbildungen näher erläutert:

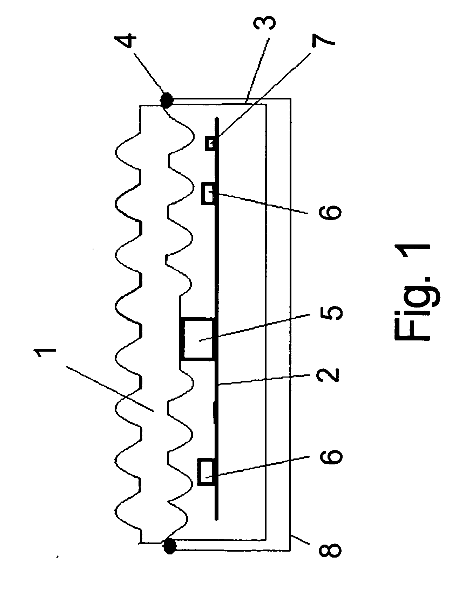

In der Figur 1 ist eine erfindungsgemäße Vorrichtung schematisch skizziert.

Dabei ist ein auf das Gehäuseteil 8 als Unterteil aufsetzbares Gehäuseteil 1 mit Kühlkörper als Oberteil aufsetzbar.

Die Leiterplatte 2 ist zumindest teilweise mittels SMD-Technik bestückt und in einer Schale 3 vorgesehen, wobei eine Vergussmasse in der Schale derart vorgesehen ist, dass die Leiterplatte 2 und wärmeerzeugende Bauelemente 6 vollständig bedeckt sind mit der Vergussmasse. Auch weitere Bauelemente 7 sind vollständig bedeckt.

Nur die Kontaktflächen der Leistungsmodule 5 zur Wärmeabgabe an den Kühlkörper sind nicht überdeckt mit Vergussmasse und somit direkt vom Kühlkörper berührbar angeordnet. Der Kühlkörper weist eine entsprechende Kontaktfläche auf. Eine oder beide der Kontaktflächen sind mit Wärmeleitpaste versehbar zur Verminderung des Wärmeübergangswiderstandes. Die Kontaktflächen sind eben ausgeführt und werden mittels eines Federelements gegeneinander gedrückt.

Das Federelement ist auf verschiedene Weisen realisierbar. In einer ersten Variante ist ein Federelement zwischen Leistungsmodul 5 und Leiterplatte angebracht oder die Füßchen des Leistungsmoduls selbst sind als Federelemente verwendet. Bei einer anderen Variante ist das Federelement zwischen Schale 3 und Leistungsmodul 5 vorgesehen, so dass dieses auf die Kontaktfläche am Kühlkörper gedrückt wird. Bei einer anderen Variante ist das Federelement zwischen Gehäuseteil 8 und Schale 3 vorgesehen, so dass das über die Schale und der darin verbundenen Leiterplatte das Leistungsmodul 5 auf die Kontaktfläche des Kühlkörper gedrückt wird.

Der Kühlkörper weist an seiner Innenseite und an seiner Außenseite Erhebungen, wie Kühlrippen und Kühlfinger, auf, so dass die Oberfläche zur äußeren Umgebung, also Luft oder eine Flüssigkeit, wie Öl oder Wasser, hin vergrößert ist. Ebenso ist die nach innen gerichtete Oberfläche vergrößert, wobei die Erhebungen an der Innenseite, also Kühlrippen und Kühlfinger, in die Vergussmasse gedrückt werden, um einen möglichst geringen Wärmeübergangswiderstand zu erreichen.

Die Schale ist derart ausgeführt, dass sie geldicht ist, also die Vergussmasse in ihr gehalten ist. An der zum Kühlkörper hin zugewandten Oberfläche ist bei einer anderen erfindungsgemäßen Ausführung eine Folie aufgelegt, um das Anhaften von Verschmutzungspartikeln an die Vergussmasse zu verhindern. Die Folie ist derart dünn und elastisch ausgeführt, dass der Kühlkörper mit seinen an der Innenseite vorgesehenen Erhebungen in die Folie gedrückt wird und sich die Folie dabei eng an ihn anschmiegt. Der Wärmeübergangswiderstand zwischen Vergussmasse und Kühlkörper ist dabei nur geringfügig verschlechtert.

In allen Ausführungsbeispielen ist die Schale mit dem Kühlkörper derart verbunden, dass die Vergussmasse nicht herausfließen kann. Die Vergussmasse ist vorzugsweise als Gel ausgeführt und somit die Verbindung also geldicht ausgeführt. Öffnungen sind dabei derart klein, dass die Vergussmasse in der Schale gehalten ist. Zum Halten der Vergussmasse tragen auch die Erhebungen des Kühlkörpers ein, da der Kühlkörper mit der Schale zusammen den Raumbereich für die Vergussmasse begrenzt.

Vorzugsweise ist die Vergussmasse ein siliconhaltiger Stoff, beispielsweise Silikonkautschuk. Vorzugsweise ist er transparent ausgeführt, um die Sichtung der Bauteile zu ermöglichen und somit Defekte schnell und klar erkennbar zu machen.

Die Vergussmasse ist bevorzugt ein gelartiges Vulkanisat, das bei der Herstellung gießbar ist, bei Raumtemperatur vulkanisierbar und additionsvernetzend und als Zweikomponenten-Siliconkautschuk gewählt.

Die Wärmeleitfähigkeit ist mindestens 6 mal besser als bei Luft, vorzugsweise 8 mal besser.

Insbesondere bei der Verwendung des Siliconkautschuks ist ein sehr guter Wärmeübergang von den wärmeerzeugenden Bauelementen 6 zur Vergussmasse erreicht. Somit ist die Wärme schnell abführbar in die Vergussmasse. Die Bauelemente sind vom Hersteller spezifiziert für einen Betrieb bis zu einer maximal zulässigen Spitzen-Temperatur im Halbleitermaterial des Bauelements und bis zu einer maximal zulässigen Umgebungstemperatur. Die Bauelemente sind hierbei SMD-montierbar. Bei der Erfindung ist nun erkannt worden, dass statt der ansonsten vorgesehenen Umgebung aus Luft die Vergussmasse verwendet ist, die wegen ihrer hohen Wärmeleitfähigkeit und wegen der besonders guten thermischen Ankoppelung an die Oberfläche des Bauelements zur Folge hat, dass der Wärmeübergangswiderstand für das Fließen der Wärme von der Oberfläche des Bauelements in die Vergussmasse sehr klein ist und somit die Wärme schnell abführbar und verteilbar ist. Daher ist es nun ermöglicht, eine höhere Umgebungstemperatur vorzusehen als die nach Bauelement-Hersteller zulässige, obwohl die maximal zulässige Spitzen-Temperatur im Halbleitermaterial des Bauelements dieselbe ist.

Auf diese Weise sind die Bauelemente über die Vergussmasse und den daran wärmetechnisch angekoppelten Kühlkörper entwärmbar, obwohl die Temperatur der Vergussmasse, also der Umgebung des Bauelements eine zu hohe Temperatur, insbesondere unerlaubt hohe Temperatur, aufweist.

Die Vergussmasse ist im Übrigen durch ihre gelartige Ausführung schwingungsdämpfend wirksam bei mechanischen Schwingungen der elektronischen Bauelemente und/oder der Schale und/oder der Leiterplatte.

Denn die Oberflächenspannung ist beim Vergießen derart gewählt, dass die Vergussmasse sich gut an die Leiterplatte und die Bauelemente anschmiegt, also keine oder nur unwesentliche Anteile an Lufteinschlüssen entstehen. Nach dem Vergießen und Vulkanisieren ist somit ein Verkleben der Bauelemente und der weiteren Teile erreicht, wobei die gelartige Vergussmasse Schwingungsenergie absorbiert. Hierbei weist die Vergussmasse eine Viskosität von 500 bis 10 000 mPa s, vorzugsweise um 1000 mPa s.

Außerdem trägt die Vergussmasse zur Isolierfestigkeit bei, da sie eine Durchschlagfestigkeit von mehr als 10 vorzugsweise 20 kV / mm aufweist und eine sehr hohe Kriechstromfestigkeit und einen hohen Durchgangswiderstand und Oberflächenwiderstand. Hierdurch sind sogar auftretende Isolationsfehler an Bauelementen heilbar, indem die Isolation in diesem Fall von der Vergussmasse übernommen wird.

Die Vergussmasse ist also völlig unterschiedlich von sogenannter Wärmeleitpaste, die zwar eine gute Wärmeleitfähigkeit aufweist, aber keine derartigen Isolationseigenschaften und auch keine schwingungsdämpfenden Eigenschaften aufweist.

In Figur 1 ist auch angedeutet, dass eine Dichtung 4 vorgesehen ist, die ein Austreten oder Ausfließen von Vergussmasse verhindert. Dabei weist die Vergussmasse eine ausgeprägte Eigenklebrigkeit auf, so dass auch bei Verformungen die Vergussmasse das Bestreben hat in ihre ursprüngliche Form zurückzukehren.

Die Leistungsmodule erzeugen sehr viel höhere Temperaturen an ihrer Oberfläche als die wärmeerzeugenden Bauelemente. Beispielsweise ist eine Temperatur der Leistungsmodule von 100 oder 120°C zulässig, die maximal erlaubte Umgebungstemperatur der Bauelemente liegt niedriger, beispielsweise bei 70°C für die umgebende Luft. Die Wärme der Leistungsmodule strömt an den Kontaktflächen von den Leistungsmodulen in den Kühlkörper, der somit direkt an der Kontaktfläche eine ähnliche Temperatur aufweist. Danach spreizt sich der Wärmestrom in den Kühlkörper hinein auf und die Oberflächentemperaturen nehmen mit zunehmender Entfernung von der Kontaktfläche ab. Beispielsweise wird in dem zu den Bauelementen nächstbenachbarten Bereich des Kühlkörpers eine Temperatur von 80°C erreicht. Somit wäre eine Entwärmung der Bauelemente in diese Bereiche hinein unzulässig und sogar unmöglich. Mit der erfindungsgemäßen Vergussmasse ist jedoch bei gleicher Temperatur innerhalb des Bauelementes wegen des verringerten Wärmeübergangswiderstandes zur Vergussmasse eine höhere Umgebungstemperatur für das Bauelement erlaubt. Die Vergussmasse darf also 80°C aufweisen und es wird trotzdem das Bauelement nicht gefährdet und genügend viel Wärme abtransportiert. Die Spitzenleistung des Bauelements bleibt ebenso gleich und die entsprechende Wärme wird ebenso gut abgeführt, wie bei einer Umgebungstemperatur von 70°C und Luft.

Die Erfindung ist nicht auf die genannten Temperaturwerte eingeschränkt. Wichtig ist aber die Relation der Temperaturwerte zueinander. Je nach Wahl der Vergussmasse treten andere Zahlenwerte auf.

Überraschenderweise sind also nun die Bauelemente, bei welchen eine niedrigere maximal zulässige Temperatur erlaubt ist als bei den Leistungsmodulen, über denselben Kühlkörper entwärmbar und dabei ist sogar die nach Herstellerangaben für Luft als umgebendes Medium maximal zulässige Temperatur überschreitbar.

Das Material der Folie umfasst vorzugsweise Polyethylen, Polycarbonat oder Polyvinylchlorid.

Bei weiteren erfindungsgemäßen Ausführungsbeispielen weist der Kühlkörper derartige Erhebungen an seiner Innenseite auf, dass die Wärme der Bauelemente besonders gut abführbar ist. Insbesondere ist also eine jeweilige Erhebung, wie Kühlfinger oder Kühlkörper auf das zu entwärmende Bauelement gerichtet ausgeführt. Dies bedeutet unter anderem, dass der Abstand von der Spitze zum Bauelement der geringste Abstand des Kühlkörpers zum Bauelement ist. Alternativ sind auch mehrere Erhebungen im Umgebungsbereich zum Bauelement ausgeformt, um einen möglichst kleinen Wärmeübergangswiderstand zu erreichen und somit die Wärme möglichst gut in den Kühlkörper zu überführen.

### Bezugszeichenliste

- 1: Gehäuseteil mit Kühlkörper
- 2: Leiterplatte
- 3: Schale
- 4: Dichtung
- 5: Leistungsmodul
- 6: Wärme erzeugendes Bauelement
- 7: weiteres Bauelement
- 8: Gehäuseteil

## Patentansprüche

1. Elektrisches Gerät,
umfassend ein einen Kühlkörper umfassendes Gehäuseteil (1, 8) und eine Leiterplatte (2), die mit Wärme erzeugenden Bauelementen (6) und mindestens einem Leistungsmodul (5) bestückt ist,
wobei
die Leiterplatte (2) in einer mit Vergussmasse zumindest teilweise befüllten Schale (3) vorgesehen ist **und mit der Schale (3) verbunden ist,**
wobei das Leistungsmodul (5) an seiner Oberfläche eine höhere Temperatur als die Bauelemente (6) an ihrer Oberfläche aufweist, insbesondere als Spitzentemperatur während des Betriebs des Geräts,
wobei die Leistungsmodule (5) eine Kontaktfläche aufweisen, die in Berührung steht mit einer Kontaktfläche des Kühlkörpers zur Ableitung von Wärme an den Kühlkörper,
wobei Entwärmung der Bauelemente (6) über die Vergussmasse zum Kühlkörper hin vorgesehen ist,
wobei Erhebungen an der Innenseite des Kühlkörpers In die Vergussmasse sich hinein erstreckend vorgesehen sind,
wobei die Erhebungen Kühlrippen oder Kühlfinger sind,
wobei die Erhebungen an der Innenseite auf ein jeweiliges Bauelement (6) gerichtet sind zur Verringerung des Wärmeübergangswiderstandes vom Bauelement (6) zum Kühlkörper,
**dadurch gekennzeichnet, dass**
die Innenseite des Kühlkörpers mit der Vergussmasse über eine auf der Vergussmasse aufliegende Folie in wärmeleitender Verbindung steht,
wobei die Folie auf der Vergussmasse aufgebracht ist,
wobei die Innenseite des Kühlkörpers die Folie berührt und somit der Wärmetransport von dem jeweiligen Bauelement (6) im Wesentlichen über die Vergussmasse und danach die Folie bis zum Kühlkörper und von dort an die Umgebung vorgesehen ist,
und dass die Schale (3) in einem zentralen Gehäuseteil (1, 8) lösbar verbunden ist, wobei das den Kühlkörper umfassende Gehäuseteil (1, 8) auf das zentrale Gehäuseteil (1, 8) verbindbar ist,
wobei das zentrale Gehäuseteil (1, 8) Mittel zur Verbindung mit der Schale (3) umfasst und auch Lageraufnahmebereiche zur Aufnahme mindestens eines der Lager des Rotors eines Elektromotors und mindestens eines der Lager einer abtreibenden Welle eines Getriebes, dessen eintreibende Welle mit der Rotorwelle verbunden ist oder die Rotorwelle ist.

2. Elektrisches Gerät nach mindestens einem der vorangegangenen Ansprüche,
**dadurch gekennzeichnet, dass**
die Umgebungstemperatur der Bauelemente (6), insbesondere in der umgebenden Vergussmasse, höher ist, insbesondere dauerhaft höher ist, als die maximal zulässige Umgebungstemperatur, insbesondere bei Luft als umgebendem Medium.

3. Elektrisches Gerät nach mindestens einem der vorangegangenen Ansprüche,
**dadurch gekennzeichnet, dass**
die maximal zulässige Umgebungstemperatur eine Herstellerangabe ist, bei dessen dauerhafter Überschreitung eine Zerstörung des Bauelements (6) wahrscheinlich oder sogar sicher ist.

4. Elektrisches Gerät nach mindestens einem der vorangegangenen Ansprüche,
**dadurch gekennzeichnet, dass**
der Kühlkörper an seiner Außenseite Erhebungen, wie Kühlrippen oder Kühlfinger, aufweist, insbesondere zur Vergrößerung der Oberfläche für den Wärmeübergang vom Kühlkörper an das außen umgebende Medium.

5. Elektrisches Gerät nach mindestens einem der vorangegangenen Ansprüche,
**dadurch gekennzeichnet, dass**
die Vergussmasse ein Siliconhaltiges Gel ist, insbesondere ein Siliconkautschuk.

6. Elektrisches Gerät nach mindestens einem der vorangegangenen Ansprüche,
**dadurch gekennzeichnet, dass**
die Vergussmasse eine Wärmeleitfähigkeit aufweist, die mindestens 6 mal höher ist als die Wärmeleitfähigkeit bei Luft bei Raumtemperatur und 1 bar, insbesondere mindestens 8 mal höher.

7. Elektrisches Gerät nach mindestens einem der vorangegangenen Ansprüche,
**dadurch gekennzeichnet, dass**
die Folie auf der Vergussmasse aufgebracht ist zum Schutz gegen Verschmutzung bei der Lagerung der Schale (3) vor Zusammenbau des Geräts.

8. Elektrisches Gerät nach mindestens einem der vorangegangenen Ansprüche,
**dadurch gekennzeichnet, dass**
das zentrale Gehäuseteil (1, 8) zur Entwärmung des Motors und des Getriebes vorgesehen ist und zwischen dem den Kühlkörper umfassenden Gehäuseteil (1, 8) und dem zentralen Gehäuseteil (1, 8) eine Wärmesperre vorgesehen ist.

9. Elektrisches Gerät nach mindestens einem der vorangegangenen Ansprüche,
**dadurch gekennzeichnet, dass**
die Wärmesperre zumindest teilweise durch eine lange, an der Oberfläche des Gehäuses verlaufende kürzeste Verbindungslinie zwischen dem Oberflächenbereich des Kühlkörpers und demjenigen Oberflächenbereich, in welchem der wesentliche Teil der Wärme des Motors und des Getriebes einströmt, realisiert ist.

10. Elektrisches Gerät nach mindestens einem der vorangegangenen Ansprüche,
**dadurch gekennzeichnet, dass**
das Gerät ein Kompaktantrieb, umfassend ein Getriebe, das von dem Elektromotor antreibbar ist, der von einer Umrichterelektronik, umfassend die Leiterplatte (2), versorgt und gesteuert ist.

11. Elektrisches Gerät nach mindestens einem der vorangegangenen Ansprüche,
**dadurch gekennzeichnet, dass**
zwischen den im zentralen Gehäuseteil (1, 8) vorgesehenen Getriebe und Elektromotor und der zwischen der Schale (3) und dem den Kühlkörper umfassenden Gehäuseteil (1,8) angeordneten Elektronik eine Wärmesperre angeordnet ist, die die Schale (3) umfasst.

## Claims

1. Electrical device,
comprising a housing part (1, 8), which comprises a heat sink, and a circuit board (2) fitted with heat-generating components (6) and at least one power module (5),
wherein the circuit board (2) is provided in a shell (3), at least partly filled with potting compound, and is connected to the shell (3),
wherein the power module (5) has at its surface a higher temperature than the components (6) at their surface, in particular as a peak temperature during the operation of the device,
wherein the power modules (5) have a contact surface which is in contact with a contact surface of the heat sink for removing heat to the heat sink,
wherein heat dissipation of the components (6) is provided via the potting compound to the heat sink,
wherein protrusions are provided on the inner side of the heat sink so as to extend into the potting compound,
wherein the protrusions are cooling fins or cooling fingers,
wherein the protrusions on the inner side are directed at a respective component (6) to reduce the heat transmission resistance from the component (6) to the heat sink,
**characterised in that** the inner side of the heat sink is in heat-conducting connection with the potting compound via a film lying on the potting compound,
wherein the film is applied to the potting compound,
wherein the inner side of the heat sink touches the film and thus the heat transfer is provided from the respective component (6), substantially via the potting compound and after that the film, to the heat sink and from there to the surroundings,
and **in that** the shell (3) is detachably connected in a central housing part (1, 8), the housing part (1, 8), which comprises the heat sink, being connectable to the central housing part (1, 8),
wherein the central housing part (1, 8) comprises means for connection to the shell (3) and also bearing-receiving regions for receiving at least one of the bearings of the rotor of an electric motor and at least one of the bearings of an output shaft of a gearing, the input shaft of which is connected to the rotor shaft or is the rotor shaft.

2. Electrical device according to at least one of the preceding claims,
**characterised in that**
the ambient temperature of the components (6), in particular in the surrounding potting compound, is higher, in particular is permanently higher, than the maximum permissible ambient temperature, in particular in the case of air as the surrounding medium.

3. Electrical device according to at least one of the preceding claims,
**characterised in that**
the maximum permissible ambient temperature is a manufacturer's specification, which if permanently exceeded makes destruction of the component (6) likely or even certain.

4. Electrical device according to at least one of the preceding claims,
**characterised in that**
the heat sink has, on its outer side, protrusions, such as cooling fins or cooling fingers, in particular for increasing the surface area for the heat transmission from the heat sink to the externally surrounding medium.

5. Electrical device according to at least one of the preceding claims,
**characterised in that**
the potting compound is a silicone-containing gel, in particular a silicone rubber.

6. Electrical device according to at least one of the preceding claims,
**characterised in that**
the potting compound has a thermal conductivity which is at least 6 times higher than the thermal conductivity in the case of air at room temperature and 1 bar, in particular at least 8 times higher.

7. Electrical device according to at least one of the preceding claims,
**characterised in that**
the film is applied to the potting compound to protect against contamination during storage of the shell (3) before assembly of the device.

8. Electrical device according to at least one of the preceding claims,
**characterised in that**
the central housing part (1, 8) is provided for heat dissipation of the motor and of the gearing and a thermal barrier is provided between the housing part (1, 8), which comprises the heat sink, and the central housing part (1, 8).

9. Electrical device according to at least one of the preceding claims,
**characterised in that**
the thermal barrier is at least partly realised by a long shortest connecting line, extending on the surface of the housing, between the surface region of the heat sink and the surface region in which the substantial part of the heat of the motor and of the gearing flows in.

10. Electrical device according to at least one of the preceding claims,
**characterised in that**
the device is a compact drive, comprising a gearing drivable by the electric motor which is supplied and controlled by converter electronics, comprising the circuit board (2).

11. Electrical device according to at least one of the preceding claims,
**characterised in that**
between the gearing and electric motor, provided in the central housing part (1, 8), and the electronics arranged between the shell (3) and the housing part (1, 8) comprising the heat sink, there is arranged a thermal barrier which encompasses the shell (3).

## Revendications

1. Appareil électrique,
comprenant une partie de boîtier (1, 8) comportant un dissipateur thermique et une carte de circuits imprimés (2) qui est équipée de composants (6) produisant de la chaleur et d'au moins un module de puissance (5),
la carte de circuits imprimés (2) étant prévue dans une coque (3) au moins partiellement remplie d'une masse de scellement et reliée à la coque (3),
le module de puissance (5) présentant à sa surface une température plus élevée que les composants (6) à leur surface, en particulier en tant que température maximale pendant le fonctionnement de l'appareil,
les modules de puissance (5) présentant une surface de contact qui est en contact avec une surface de contact du dissipateur thermique pour dissiper la chaleur sur le dissipateur thermique,
la dissipation de chaleur des composants (6) vers le dissipateur thermique étant prévue par la masse de scellement,
des élévations étant prévues sur le côté intérieur du dissipateur thermique, lesquelles s'étendent à l'intérieur de la masse de scellement,
les élévations étant des ailettes de refroidissement ou des doigts de refroidissement,
les élévations sur le côté intérieur étant dirigées vers un composant (6) respectif pour diminuer la résistance de passage de chaleur du composant (6) vers le dissipateur thermique,
**caractérisé en ce que**
le côté intérieur du dissipateur thermique étant en liaison conductrice de chaleur avec la masse de scellement par une feuille reposant sur la masse de scellement,
la feuille étant appliquée sur la masse de scellement,
le côté intérieur du dissipateur thermique étant en contact avec la feuille et le transport de chaleur étant par conséquent prévu du composant (6) respectif sensiblement par la masse de scellement et ensuite la feuille jusqu'au dissipateur thermique et de là vers l' environnement,
et que la coque (3) est reliée de manière détachable dans une partie centrale de boîtier (1, 8), la partie de boîtier (1, 8) entourant le dissipateur thermique pouvant être reliée à la partie centrale de boîtier (1, 8),
la partie centrale de boîtier (1, 8) comprenant des moyens pour la liaison avec la coque (3) ainsi que des zones de logement de palier pour recevoir au moins un des paliers du rotor d'un moteur électrique et au moins un des paliers d'un arbre de sortie d'une transmission dont l'arbre d'entrée est relié à l'arbre de rotor ou est l'arbre de rotor.

2. Appareil électrique selon au moins l'une des revendications précédentes,
**caractérisé en ce que**
la température ambiante des composants (6), en particulier dans la masse de scellement environnante, est plus élevée, en particulier durablement plus élevée, que la température ambiante maximale admissible, en particulier lorsque le milieu environnant est de l'air.

3. Appareil électrique selon au moins l'une des revendications précédentes,
**caractérisé en ce que**
la température ambiante maximale admissible est une température indiquée par le fabricant dont le dépassement durable entraîne une destruction probable voire certaine du composant (6).

4. Appareil électrique selon au moins l'une des revendications précédentes,
**caractérisé en ce que**
le dissipateur thermique présente sur son côté extérieur des élévations, telles que des ailettes de refroidissement ou des doigts de refroidissement, en particulier pour agrandir la surface pour le passage de chaleur du dissipateur thermique vers le milieu environnant extérieur.

5. Appareil électrique selon au moins l'une des revendications précédentes,
**caractérisé en ce que**
la masse de scellement est un gel contenant du silicone, en particulier un caoutchouc de silicone.

6. Appareil électrique selon au moins l'une des revendications précédentes,
**caractérisé en ce que**
la masse de scellement présente une conductibilité thermique qui est au moins 6 fois plus élevée que la conductibilité thermique dans l'air à la température ambiante et à 1 bar, en particulier au moins 8 fois plus élevée.

7. Appareil électrique selon au moins l'une des revendications précédentes,
**caractérisé en ce que**
la feuille est appliquée sur la masse de scellement pour la protection contre la contamination pendant le stockage de la coque (3) avant assemblage de l'appareil.

8. Appareil électrique selon au moins l'une des revendications précédentes,
**caractérisé en ce que**
la partie centrale de boîtier (1, 8) est prévue pour dissiper la chaleur du moteur et de la transmission et une barrière thermique est prévue entre la partie de boîtier (1, 8) comportant le dissipateur thermique et la partie centrale de boîtier (1, 8).

9. Appareil électrique selon au moins l'une des revendications précédentes,
**caractérisé en ce que**
la barrière thermique est réalisée au moins partiellement par une longue ligne de liaison s'étendant à la surface du boîtier, la plus courte entre la zone de surface du dissipateur thermique et la zone de surface dans laquelle la majeure partie de la chaleur du moteur et de la transmission afflue.

10. Appareil électrique selon au moins l'une des revendications précédentes,
**caractérisé en ce que**
l'appareil est un entraînement compact, comprenant une transmission qui peut être entraînée par le moteur électrique, qui est alimenté et commandé par une électronique de variateur qui comprend la carte de circuit imprimés (2).

11. Appareil électrique selon au moins l'une des revendications précédentes,
**caractérisé en ce que**
une barrière thermique, qui comprend la coque (3), est disposée entre la transmission et le moteur électrique prévus dans la partie centrale de boîtier (1, 8) et l'électronique disposée entre la coque (3) et la partie de boîtier (1, 8) comportant le dissipateur thermique. 1
